# EUROPEAN PATENT APPLICATION

(11) **EP 4 418 069 A1**
(43) Date of publication of application: **21.08.2024**
(21) Application number: 23182809.6
(22) Date of filing: 30.06.2023
(51) Int. Cl.: G06F 1/16

(54) **A HINGE COMPRISING A MOVABLE SUPPORT PLATE, AND AN ELECTRONIC DEVICE WITH THE HINGE**

(30) Priority: 17.02.2023 CN 202310183678
(71) Applicant: Beijing Xiaomi Mobile Software Co., Ltd., Beijing 100085 (CN)
(72) Inventor: LIU, Jianwei, Beijing 100085 (CN)
(74) Representative: dompatent von Kreisler Selting Werner - Partnerschaft von Patent- und Rechtsanwälten mbB

(57) **Abstract**

The present disclosure relates to the field of electronic device technologies, and more specifically, to a hinge and an electronic device with the hinge. The hinge includes: a base; a supporting plate; and a first rotating assembly and a second rotating assembly, each of the first rotating assembly and the second rotating assembly being rotatably arranged on the base between an unfolded position and a folded position, and at least one of the first rotating assembly and the second rotating assembly fitting with the supporting plate so as to move the supporting plate in a thickness direction of the base. The hinge of the present disclosure can actively control the bending shape of the wire arrangement.

## Description

### TECHNICAL FIELD

The present disclosure relates to the field of electronic device technologies, and more specifically, to a hinge and an electronic device with a hinge.

### BACKGROUND

An electronic device with a foldable screen can provide users with a larger size screen to improve the user's visual experience. In order to make a wire arrangement of an electronic device in a folded state have an enough length, the wire arrangement of the electronic device in an unfolded state is in a bent state.

### SUMMARY

The present disclosure intends to solve the technical problems in the related technologies at least to some extent. Therefore, the present disclosure provides a hinge and an electronic device with a hinge.

A hinge according to the present disclosure includes: a base; a supporting plate; and a first rotating assembly and a second rotating assembly, each of the first rotating assembly and the second rotating assembly being rotatably disposed on the base between an unfolded position and a folded position, and at least one of the first rotating assembly and the second rotating assembly cooperating with the supporting plate to move the supporting plate in a thickness direction of the base.

The hinge of the present disclosure can actively control the bending shape of the wire arrangement, such that the bending shape of the wire arrangement is smoother, so as to improve the service life of the wire arrangement, and thereby to improve the service life of the electronic device.

An electronic device according to the present disclosure includes: the hinge according to the present disclosure as described above; and a wire arrangement connected with the supporting plate of the hinge.

### BRIEF DESCRIPTION OF THE DRAWINGS

FIG. 1 is a partial exploded view of an electronic device according to an example of the present disclosure.
FIG. 2 is a schematic diagram of partial structure of an electronic device according to an example of the present disclosure.
FIG. 3 is a schematic diagram of partial structure of a hinge of an electronic device according to an example of the present disclosure.
FIG. 4 is a schematic diagram of partial structure of an electronic device according to an example of the present disclosure, wherein a first rotating assembly and a second rotating assembly are in an unfolded position.
FIG. 5 is a schematic diagram of partial structure of an electronic device according to an example of the present disclosure, wherein a first rotating assembly and a second rotating assembly are in a folded position.
FIG. 6 is a schematic diagram of partial structure of an electronic device according to the example of the present disclosure, wherein the electronic device is in an unfolded state.
FIG. 7 is a schematic diagram of structure of a first housing and a second housing of an electronic device according to an example of the present disclosure.
FIG. 8 is an exploded view of a hinge of an electronic device according to an example of the present disclosure.
FIG. 9 is a schematic diagram of structure of a hinge of an electronic device according to an example of the present disclosure, wherein a first rotating assembly and a second rotating assembly are in a folded position.

### DETAILED DESCRIPTION

Hereinafter, examples of the present disclosure are described in detail, examples of which are illustrated in the accompanying drawings. The examples described below by referring to the drawings are exemplary and are intended to explain the present disclosure, and are not to be construed as limiting the present disclosure.

The wire arrangement of the electronic device of according to the known related technologies has the defect of a short service life.

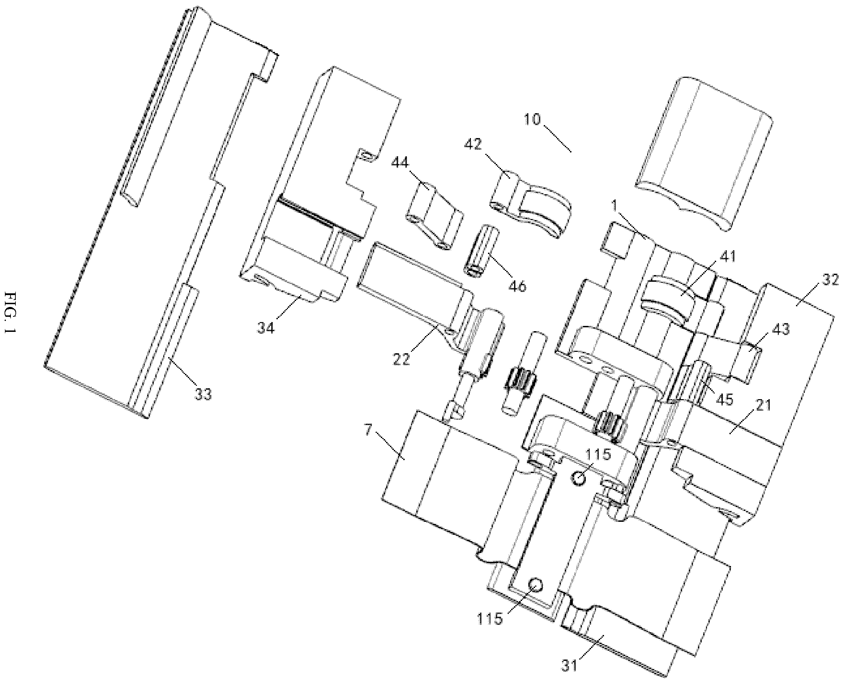

As shown in FIGS. 1 to 9, an electronic device according to the present disclosure includes a hinge 10 and a wire arrangement 7. The hinge 10 includes a base 1, a first rotating assembly 3a, a second rotating assembly 3b and a supporting plate 5.

Each of the first rotating assembly 3a and the second rotating assembly 3b is rotatably disposed on the base 1 between an unfolded position and a folded position. At least one of the first rotating assembly 3a and the second rotating assembly 3b is matched with/adapted to the supporting plate 5 so as to move the supporting plate 5 in a thickness direction of the base 1.

The electronic device and the hinge 10 according to the present disclosure are provided with the supporting plate 5 movable in the thickness direction of the base 1 and the supporting plate 5 are made to be matched with the at least one of the first rotating assembly 3a and the second rotating assembly 3b, thereby the at least one of the first rotating assembly 3a and the second rotating assembly 3b can drive the wire arrangement 7 to move along the thickness direction of the base 1 when the first rotating assembly 3a and the second rotating assembly 3b rotate between the unfolded position and the folded position, that is, when the electronic device and the hinge 10 are changed between the unfolded state and the folded state.

Therefore, the bending form or shape of the wire arrangement 7 can be actively controlled and adjusted when the electronic device and the hinge 10 are unfolded and folded, thereby the bending form of the wire arrangement 7 can be smoother regardless of whether the electronic device and the hinge 10 are unfolded or folded, so as to improve the service life of the wire arrangement 7, and further improve the service life of the electronic device.

The electronic device can be a mobile phone, a tablet computer, a notebook computer, etc. As shown in FIGS. 1 to 9, the electronic device according to the present disclosure includes a hinge 10, a wire arrangement 7, a first housing 61 and a second housing 62. The hinge 10 includes a base 1, a first rotating assembly 3a, a second rotating assembly 3b, a supporting plate 5, a first rotating member 21 and a second rotating member 22.

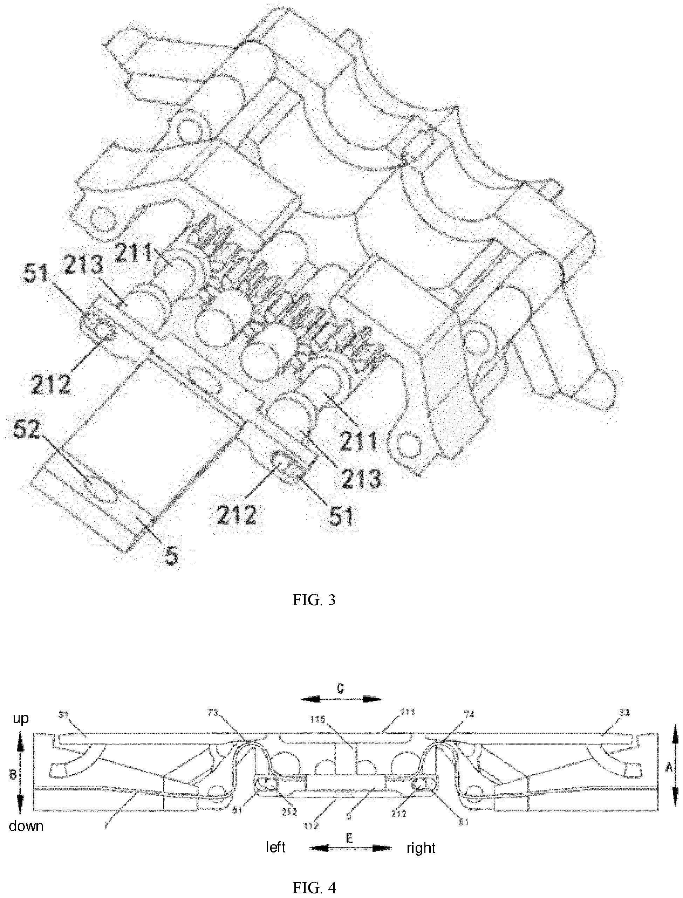

The base 1 has a support side 111 and a back side 112 which are opposite in the thickness direction of the base 1, and a screen of the electronic device can be located on the support side 111. In order to make the technical solutions of the present disclosure easier to understand, the technical solutions of the present disclosure will be further described by taking the thickness direction of the base 1 being an up-down direction as an example, the thickness direction of the base 1 is shown by arrow A in FIG. 4, and the up-down (vertical) direction is shown by arrow B in FIG. 4. Therefore, the electronic device and the hinge 10 are horizontally disposed when the electronic device and the hinge 10 are in the unfolded state, that is, when the first rotating assembly 3a and the second rotating assembly 3b are located in the unfolded position.

Each of the first rotating assembly 3a and the second rotating assembly 3b is rotatably disposed between the unfolded position and the folded position. The electronic device and the hinge 10 are in the unfolded state when the first rotating assembly 3a and the second rotating assembly 3b are in the unfolded position, and the electronic device and the hinge 10 are in the folded state when the first rotating assembly 3a and the second rotating assembly 3b are in the folded position.

Optionally, the at least one of the first rotating assembly 3a and the second rotating assembly 3b drives the supporting plate 5 and the wire arrangement 7 to move toward the support side 111 along the thickness direction of the base 1 when the first rotating assembly 3a and the second rotating assembly 3b are rotated from the unfolded position to the folded position. The at least one of the first rotating assembly 3a and the second rotating assembly 3b drives the supporting plate 5 and the wire arrangement 7 to move toward the back side 112 along the thickness direction of the base 1, that is, the at least one of the first rotating assembly 3a and the second rotating assembly 3b drives the supporting plate 5 and the wire arrangement 7 to move away from the support side 111 along the thickness direction of the base 1, when the first rotating assembly 3a and the second rotating assembly 3b are rotated from the folded position to the unfolded position. That is to say, the hinge 10 of the present application can be an inward foldable hinge.

In addition, the at least one of the first rotating assembly 3a and the second rotating assembly 3b drives the supporting plate 5 and the wire arrangement 7 to move toward the back side 112 along the thickness direction of the base 1 when the first rotating assembly 3a and the second rotating assembly 3b are rotated from the unfolded position to the folded position. The at least one of the first rotating assembly 3a and the second rotating assembly 3b drives the supporting plate 5 and the wire arrangement 7 to move toward the support side 111 along the thickness direction of the base 1 when the first rotating assembly 3a and the second rotating assembly 3b are rotated from the folded position to the unfolded position. That is to say, the hinge 10 of the present application can be an outward foldable hinge.

To sum up, the hinge 10 of the present application can be an inward foldable hinge or an outward foldable hinge.

Therefore, the bending form of the wire arrangement 7 can be actively controlled and adjusted when the electronic device and the hinge 10 are unfolded and folded, such that the bending form of the wire arrangement 7 can be smoother regardless of whether the electronic device and the hinge 10 are unfolded or folded, so as to improve the service life of the wire arrangement 7, and further improve the service life of the electronic device.

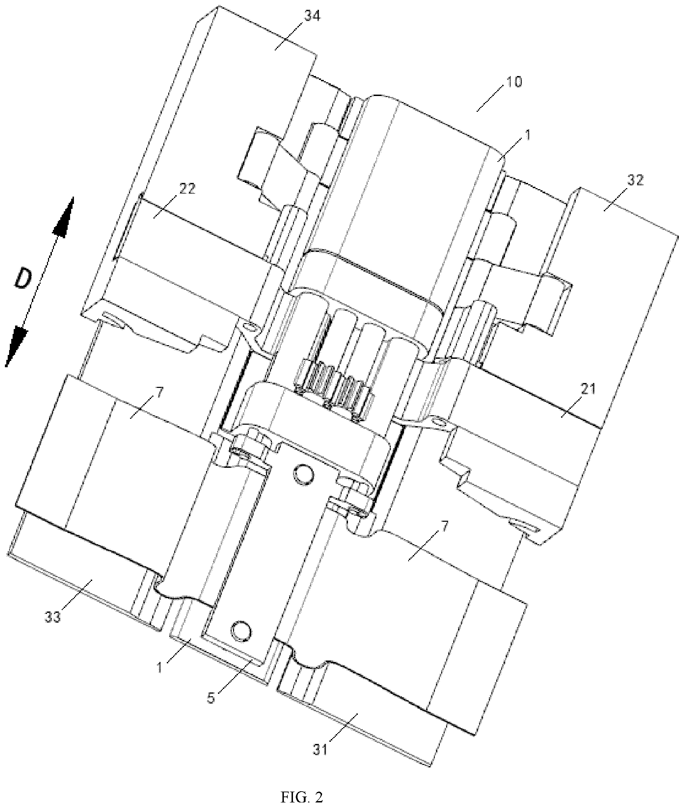

Each of the first rotating member 21 and the second rotating member 22 is rotatably disposed on the base 1, the first rotating member 21 and the second rotating member 22 are disposed along a first direction at intervals, and the first direction is one of a width direction and a length direction of the base 1. For example, the first direction is the width direction of the base 1. Therefore, the first rotating assembly 3a and the second rotating assembly 3b located in the unfolded position are spaced along the first direction, and the first housing 61 and the second housing 62 of the electronic device in the unfolded state are arranged in the first direction. The width direction of the base 1 is shown by arrow C in FIG. 4, and the length direction of the base 1 is shown by arrow D in FIG. 2.

The first rotating member 21 is connected with the first rotating assembly 3a, and the second rotating member 22 is connected with the second rotating assembly 3b. Optionally, the first rotating member 21 is a first synchronizing member, and the second rotating member 22 is a second synchronizing member. The first synchronizing member and the second synchronizing member can synchronously rotate the first rotating assembly 3a and the second rotating assembly 3b in a known manner. Since this has nothing to do with the inventive point of the present application, it will not be described in detail.

As shown in FIGS. 1, 2, 4 and 5, the supporting plate 5 is movably disposed on the base 1 along the thickness direction of the base 1, thereby the supporting plate 5 can be installed more conveniently and stably.

A middle part 79 of the wire arrangement 7 in its extending direction is connected to the supporting plate 5, and the middle part 79 of the wire arrangement 7 is located between the supporting plate 5 and the base 1 in the thickness direction of the base 1. Therefore, the bending form of the wire arrangement 7 can be better actively controlled when the electronic device and the hinge 10 are unfolded and folded, such that the bending form of the wire arrangement 7 is smoother, so as to further improve the service life of the wire arrangement 7, and further improve the service life of the electronic device.

As shown in FIGS. 1 to 5, one of the base 1 and the supporting plate 5 is provided with a first guiding part 115, and the other of the base 1 and the supporting plate 5 is provided with a second guiding part 52, and the first guiding part 115 is fitted with the second guiding part 52. Therefore, the middle part 79 of the wire arrangement 7 and the supporting plate 5 can move more stably along the thickness direction of the base 1, so as to better actively control the bending form of the wire arrangement 7 and make the bending form of the wire arrangement 7 smoother.

One of the first guiding part 115 and the second guiding part 52 is a guiding post, the guiding post extends in the thickness direction of the base 1, the other of the first guiding part 115 and the second guiding part 52 is a guiding hole, and the guiding post is matched within the guiding hole.

Optionally, the first guiding part is plural and the plurality of first guiding parts 115 are spaced along a second direction, the second guiding part is plural and the plurality of second guiding parts 52 are spaced along the second direction. The plurality of first guiding portions 115 are fitted with the plurality of second guiding portions 52 in one-to-one correspondence. The second direction is one of the width direction and the length direction of the base 1, for example, the second direction is the length direction of the base 1. Therefore, the middle part 79 of the wire arrangement 7 and the supporting plate 5 can move more stably along the thickness direction of the base 1, and the supporting plate 5 can be prevented from rotating in a plane perpendicular to the thickness direction of the base 1, thereby the bending form of the wire arrangement 7 can be better actively controlled, such that the bending form of the wire arrangement 7 can be smoother.

At least one of the first rotating member 21 and the second rotating member 22 is connected to the supporting plate 5. That is to say, the at least one of the first rotating assembly 3a and the second rotating assembly 3b is matched with the supporting plate 5 through the at least one of the first rotating member 21 and the second rotating member 22.

The at least one of the first rotating member 21 and the second rotating member 22 drives the wire arrangement 7 and the supporting plate 5 to move toward the support side 111 along the thickness direction of the base 1 when the first rotating assembly 3a and the second rotating assembly 3b rotate from the unfolded position to the folded position. For example, the at least one of the first rotating member 21 and the second rotating member 22 drives the wire arrangement 7 and the supporting plate 5 to move upward in the thickness direction of the base 1 when the first rotating assembly 3a and the second rotating assembly 3b rotate from the unfolded position to the folded position.

The at least one of the first rotating assembly 21 and the second rotating assembly 22 drives the supporting plate 5 and the wire arrangement 7 to move toward the back side 112 along the thickness direction of the base 1, that is, the at least one of the first rotating assembly 21 and the second rotating assembly 22 drives the supporting plate 5 and the wire arrangement 7 to move away from the support side 111 along the thickness direction of the base 1, when the first rotating assembly 3a and the second rotating assembly 3b rotate from the folded position to the unfolded position. For example, the at least one of the first rotating member 21 and the second rotating member 22 drives the wire arrangement 7 and the supporting plate 5 to move downward in the thickness direction of the base 1.

As shown in FIGS. 1 to 5, the at least one of the first rotating member 21 and the second rotating member 22 includes a rod body 211 and an eccentric part 212. The rod body 211 is rotatably disposed on the base 1, and the rod body 211 is connected with a corresponding one of the first rotating assembly 3a and the second rotating assembly 3b. That is to say, the rod body 211 of the first rotating member 21 (the second rotating member 22) is connected to the first rotating assembly 3a (the second rotating assembly 3b). The eccentric part 212 is disposed on the rod body 211, and the eccentric part 212 is spaced from a rotating axis of the rod body 211 in a radial direction of the rod body 211. The eccentric part 212 is connected to the supporting plate 5. Therefore, the structure of the at least one of the first rotating member 21 and the second rotating member 22 can be made more reasonable.

The at least one of the first rotating member 21 and the second rotating member 22 further includes a first connecting part 213 extending along the radial direction of the rod body 211, one end (an inner end) of the first connecting part 213 is connected with the rod body 211, and the other end (an outer end) of the first connecting part 213 is connected with the eccentric part 212. A diameter of the rod body 211 can be reduced by providing the first connecting part 213, and the eccentric part 212 can be conveniently disposed on the rod body 211.

Optionally, the eccentric part 212 is an eccentric post. Alternatively, the eccentric part 212 is an eccentric hole, the supporting plate 5 has a second connecting part, and the second connecting part fits in the eccentric hole.

Optionally, the eccentric part 212 is an eccentric post, the supporting plate 5 is provided with a guiding hole 51 extending along the first direction, and the eccentric post (the eccentric part 212) is movably fitted in the guiding hole 51 along the first direction. Therefore, the middle part 79 of the wire arrangement 7 and the supporting plate 5 can be made to not move in the first direction, for example, the supporting plate 5 only moves in the thickness direction of the base 1, when the electronic device and the hinge 10 are folded and unfolded, thereby the bending form of the wire arrangement 7 can be better actively controlled, such that the bending form of the wire arrangement 7 can be smoother. Optionally, the guiding hole 51 is an oblong hole (long circular hole).

As shown in FIG. 4, the rotating axis of the rod body 211 is adjacent to the support side relative to the eccentric part 212 in the thickness direction of the base 1 when the first rotating assembly 3a and the second rotating assembly 3b are in the unfolded position, that is, when the electronic device and the hinge 10 are in the unfolded state. For example, the rotating axis of the rod body 211 can be located below the support side and an upper surface of the base 1, and the rotating axis of the rod body 211 can be located above the eccentric part 212.

Therefore, the travel of the eccentric part 212 in the thickness direction of the base 1 can be increased, and further the travel of the supporting plate 5 and the middle part 79 of the wire arrangement 7 in the thickness direction of the base 1 can be increased, thereby the bending form of the wire arrangement 7 can be better actively controlled when the electronic device and the hinge 10 are unfolded and folded, such that the bending form of the wire arrangement 7 is smoother, so as to further improve the service life of the wire arrangement 7, and further improve the service life of the electronic device.

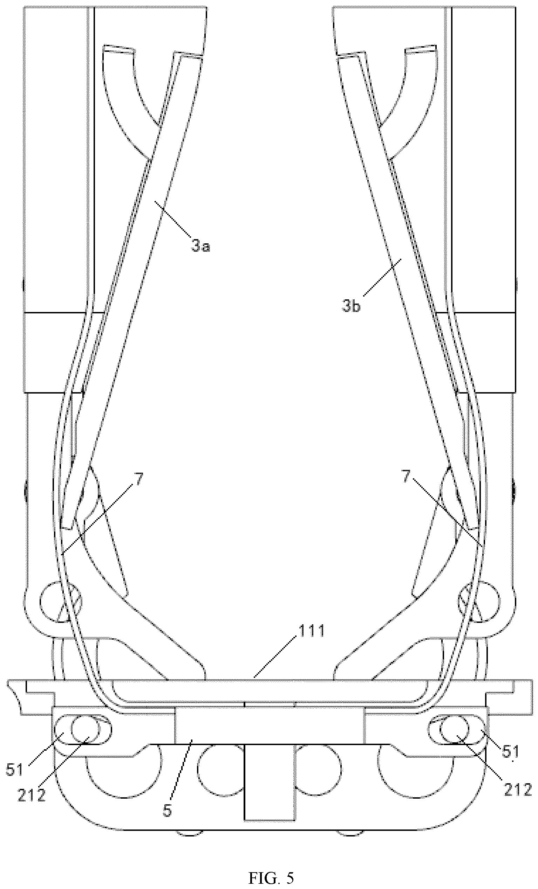

As shown in FIG. 5, the eccentric part 212 is adjacent to the support side relative to the rotating axis of the rod body 211 in the thickness direction of the base 1 when the first rotating assembly 3a and the second rotating assembly 3b are in the folded position, that is, when the electronic device and the hinge 10 are in the folded state. For example, the eccentric part 212 can be located below the support side and the upper surface of the base 1, and the eccentric part 212 can be located above the rotating axis of the rod body 211.

Therefore, the travel of the eccentric part 212 in the thickness direction of the base 1 can be increased, and further the travel of the supporting plate 5 and the middle part 79 of the wire arrangement 7 in the thickness direction of the base 1 can be increased, thereby the bending form of the wire arrangement 7 can be better actively controlled when the electronic device and the hinge 10 are unfolded and folded, such that the bending shape of the wire arrangement 7 is smoother, so as to further improve the service life of the wire arrangement 7, and further improve the service life of the electronic device.

The wire arrangement 7 has a first end 71 and a second end 72 which are opposite in its extending direction. The first end 71 is disposed on the first housing 61 and the second end 72 is disposed on the second housing 62.

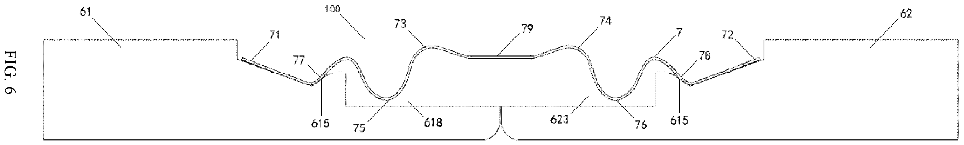

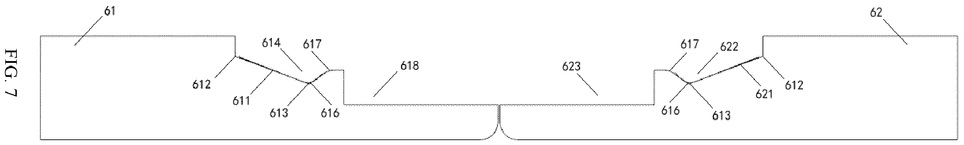

As shown in FIGS. 6 and 7, the first housing 61 is disposed on the first rotating assembly 3a, and the second housing 62 is disposed on the second rotating assembly 3b. The first housing 61 has a first inclined surface 611, the second housing 62 has a second inclined surface 621, and each of the first inclined surface 611 and the second inclined surface 621 has a first edge 612 and a second edge 613 that are opposite.

The first edge 612 and the second edge 613 are opposite in the first direction and the first edge 612 and the second edge 613 are spaced in the thickness direction of the base 1 when the first rotating assembly 3a and the second rotating assembly 3b are in the unfolded position. Therefore, the first inclined surface 611 and the second inclined surface 621 can be obliquely disposed relative to the first direction and the thickness direction of the base 1. The first end 71 is disposed on the first inclined surface 611, and the second end 72 is disposed on the second inclined surface 621.

Compared with the technical solution that the first end and the second end of the wire arrangement are disposed on a plane (such as a horizontal plane) parallel to the first direction and perpendicular to the thickness direction of the base, the length of the first end 71 and the second end 72 can be increased, that is, the length of the parts of the wire arrangement 7 disposed on the first inclined face 611 and the second inclined face 621 can be increased, by providing the first inclined face 611 and the second inclined face 621. Therefore, the length of the wire arrangement 7 can better meet requirements when the electronic device is in the folded state, and arrangement difficulty and assembly difficulty of the wire arrangement 7 can be reduced.

As shown in FIGS. 6 and 7, the first edge 612 is adjacent to the support side 111 of the base 1 of the hinge 10 relative to the second edge 613 in the thickness direction of the base 1 and the first edge 612 is far away from the base 1 relative to the second edge 613 in the first direction when the first rotating assembly 3a and the second rotating assembly 3b are in the unfolded position. Therefore, the structure of the electronic device can be made more reasonable.

For example, the first direction is a left-right direction, the first housing 61 is located on the left side of the second housing 62, the first inclined face 611 is located on the left side of the base 1, and the second inclined face 621 is located on the right side of the base 1. The first edge 612 of the first inclined face 611 is located on the left side of and above the second edge 613 of the first inclined face 611, and the first edge 612 of the second inclined face 621 is located on the right side of and above the second edge 613 of the second inclined face 621. The left-right direction is shown by arrow E in FIG. 4.

As shown in FIGS. 6 and 7, the first housing 61 has a first accommodating groove 614, and the second housing 62 has a second accommodating groove 622. Both the first accommodating groove 614 and the second accommodating groove 622 have a first side face and a second side face 615 which are opposite in the first direction when the first rotating assembly 3a and the second rotating assembly 3b are located in the unfolded position. The first side face of the first accommodating groove 614 is the first inclined surface 611, and the first side face of the second accommodating groove 622 is the second inclined surface 621.

The second side face 615 of the first accommodating groove 614 is adjacent to the base 1 relative to the first side face of the first accommodating groove 614, and the second side face 615 of the second accommodating groove 622 is adjacent to the base 1 relative to the first side face of the second accommodating groove 622 in the first direction. A portion 77 of the wire arrangement 7 adjacent to the first end 71 is disposed on the second side 615 of the first accommodating groove 614, and a portion 78 of the wire arrangement 7 adjacent to the second end 72 is disposed on the second side 615 of the second accommodating groove 622.

Thus, the length of the portions of the wire arrangement 7 disposed in the first accommodating groove 614 and the second accommodating groove 622 can be increased. Therefore, the length of the wire arrangement 7 can better meet requirements when the electronic device is in the folded state, and arrangement difficulty and assembly difficulty of the wire arrangement 7 can be further reduced.

The second side face 615 of each of the first accommodating groove 614 and the second accommodating groove 622 has a third edge 616 and a fourth edge 617 which are opposite. When the first rotating assembly 3a and the second rotating assembly 3b are located in the unfolded position, as for the same second side face 615, the third edge 616 and the fourth edge 617 are opposite in the first direction, the third edge 616 is far away from the base 1 relative to the fourth edge 617 in the first direction, and the third edge 616 is far away from the support side 111 relative to the fourth edge 617 in the thickness direction of the base 1.

Therefore, both the second side face 615 of the first accommodating groove 614 and the second side face 615 of the second accommodating groove 622 are inclined surfaces, thereby the length of the portions of the wire arrangement 7 disposed in the first accommodating groove 614 and the second accommodating groove 622 can be further increased. Therefore, the length of the wire arrangement 7 can better meet requirements when the electronic device is in the folded state, and arrangement difficulty and assembly difficulty of the wire arrangement 7 can be further reduced.

For example, the third edge 616 of the second side face 615 of the first accommodating groove 614 is located on the left side of and below the fourth edge 617 of the second side face 615 of the first accommodating groove 614, and the third edge 616 of the second side face 615 of the second accommodating groove 622 is located on the right side of and below the fourth edge 617 of the second side face 615 of the second accommodating groove 622.

Optionally, a distance between the first side face and the second side face of the first accommodating groove 614 in the first direction is less than or equal to a predetermined value, and a distance between the first side face and the second side face of the second accommodating groove 622 in the first direction is less than or equal to the predetermined value when the first rotating assembly 3a and the second rotating assembly 3b are in the unfolded position. Therefore, the sizes of the first accommodating groove 614 and the second accommodating groove 622 can be reduced, for example, the sizes of the first accommodating groove 614 and the second accommodating groove 622 in the first direction can be reduced when the first rotating assembly 3a and the second rotating assembly 3b are in the unfolded position.

For example, the first accommodating groove 614 is a first V-shaped groove, and the second accommodating groove 622 is a first V-shaped groove. That is to say, the second edge 613 of the first inclined surface 611 and the third edge 616 of the second side face 615 of the first accommodating groove 614 are located on the same straight line, and the second edge 613 of the second inclined surface 621 and the third edge 616 of the second side face 615 of the second accommodating groove 622 are located on the same straight line. Therefore, the sizes of the first accommodating groove 614 and the second accommodating groove 622 can be further reduced, for example, the sizes of the first accommodating groove 614 and the second accommodating groove 622 in the first direction can be further reduced when the first rotating assembly 3a and the second rotating assembly 3b are in the unfolded position.

As shown in FIGS. 1, 2, 8 and 9, the first rotating assembly 3a includes a first support 31 and a first movable member 32, and the second rotating assembly 3b includes a second support 33 and a second movable member 34. The first movable member 32 is connected with the first rotating member 21, and the second movable member 34 is connected with the second rotating member 22. The first housing 61 is disposed on the first movable member 32, and the second housing 62 is disposed on the second movable member 34. The first support 31 and the second support 33 can support a screen of the electronic device.

Optionally, a first part 73 of the wire arrangement 7 is connected with the first support 31, and a second part 74 of the wire arrangement 7 is connected with the second support 33. The first part 73 is located between the first end 71 and the middle part 79 of the wire arrangement 7 in the extending direction of the wire arrangement 7, and the second part 74 is located between the second end 72 and the middle part 79 of the wire arrangement 7 in the extending direction of the wire arrangement 7.

Therefore, the first support 31 can bring the first part 73 and the second support 33 can bring the second part 74 to move synchronously when the first rotating assembly 3a and the second rotating assembly 3b rotate between the unfolded position and the folded position, that is, when the electronic device and the hinge 10 are switched between the unfolded state and the folded state. Therefore, the bending form of the wire arrangement 7 can be further actively controlled and adjusted, thereby the bending form of the wire arrangement 7 can be smoother, so as to further improve the service life of the wire arrangement 7, and further improve the service life of the electronic device.

As shown in FIGS. 6 and 7, the first housing 61 has a third accommodating groove 618, and the second housing 62 has a fourth accommodating groove 623. The third part 75 of the wire arrangement 7 is located in the third accommodating groove 618 and the fourth part 76 of the wire arrangement 7 is located in the fourth accommodating groove 623 when the first rotating assembly 3a and the second rotating assembly 3b are in the unfolded position. The third part 75 is located between the first part 73 and the first end 71 in the extending direction of the wire arrangement 7, and the fourth part 76 is located between the second part 74 and the second end 72 in the extending direction of the wire arrangement 7.

Therefore, the space for accommodating the wire arrangement 7 can be increased, such that the length of the wire arrangement 7 can better meet requirements when the electronic device in the folded state, and arrangement difficulty and assembly difficulty of the wire arrangement 7 can be further reduced.

Optionally, each of the third part 75 and the fourth part 76 is arc-shaped when the first rotating assembly 3a and the second rotating assembly 3b are located in the unfolded position. Therefore, the length of the third part 75 and the fourth part 76 can be further increased, such that the length of the wire arrangement 7 can better meet requirements when the electronic device in the folded state, and arrangement difficulty and assembly difficulty of the wire arrangement 7 can be further reduced.

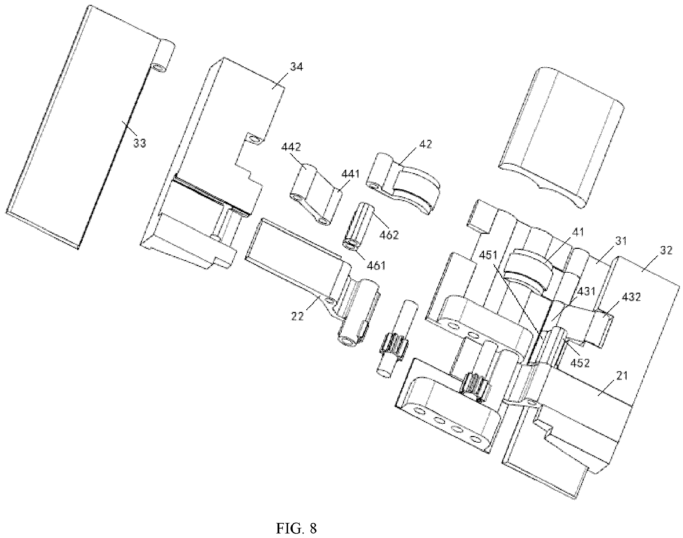

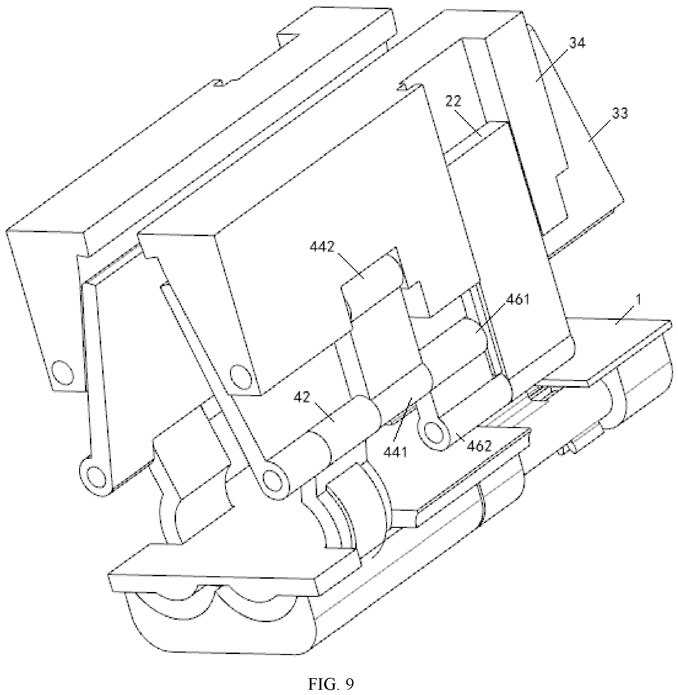

As shown in FIGS. 8 and 9, each of a first connecting member 41 and a second connecting member 42 of the hinge 10 is rotatably disposed on the base 1 between a retracted position and an extended position. The first rotating assembly 3a and the second rotating assembly 3b are in the unfolded position and the electronic device and the hinge 10 are in the unfolded state when the first connecting member 41 and the second connecting member 42 are in the retracted position. The first rotating assembly 3a and the second rotating assembly 3b are located in the folded position and the electronic device and the hinge 10 are in the folded state when the first connecting member 41 and the second connecting member 42 are located in the extended position.

The first support 31 is pivotally connected with the first connecting member 41, and the second support 33 is pivotally connected with the second connecting member 42. The pivot connection between the first support 31 and the first connecting member 41 means that the first support 31 can only rotate relative to the first connecting member 41, and besides, the first support 31 may or may not translate relative to the first connecting member 41 along its rotating axis, that is, as for whether the first support 31 can translate relative to the first connecting member 41 along its rotating axis, it is not limited in the present application. The pivot connection between the second support 33 and the second connecting member 42 means that the second support 33 can only rotate relative to the second connecting member 42, and besides, the second support 33 may or may not translate relative to the second connecting member 42 along its rotating axis, that is, this movement is not limited in the present disclosure.

That is to say, the first support 31 cannot move relative to the first connecting member 41 in a direction intersecting its rotating axis, and the second support 33 cannot move relative to the second connecting member 42 in a direction intersecting its rotating axis. The term "pivot connection" in the present application has the meaning described above, and in order to save space, the meaning of the term "pivot connection" in other places will not be described repeatedly.

The hinge 10 can accurately control the trajectories of the first support 31 and the second support 33 by pivotally connecting the first support 31 with the first connecting member 41 and pivotally connecting the second support 33 with the second connecting member 42. Therefore, the first support 31 and the second support 33 can effectively support the screen of the electronic device without jacking up a part of the screen when the first rotating assembly 3a and the second rotating assembly 3b are in the unfolded position, that is, when the electronic device and the hinge 10 are in the unfolded state, thereby the flatness of the screen can be effectively improved, so as to effectively improve the visual effect of the electronic device.

As shown in FIGS. 8 and 9, the hinge 10 further includes a third connecting member 43, a fourth connecting member 44, a fifth connecting member 45, a sixth connecting member 46, a first pivot shaft and a second pivot shaft.

The third connecting member 43 has a first end 431 and a second end 432 which are opposite, and the fourth connecting member 44 has a third end 441 and a fourth end 442 which are opposite. The second end 432 of the third connecting member 43 is pivotally connected with the first movable member 32, and the fourth end 442 of the fourth connecting member 44 is pivotally connected with the second movable member 34.

The fifth connecting member 45 has a fifth end 451 and a sixth end 452 which are opposite, and the sixth connecting member 46 has a seventh end 461 and an eighth end 462 which are opposite. The sixth end 452 is pivotally connected with the first rotating member 21, and the eighth end 462 is pivotally connected with the second rotating member 22. A rotating axis of the sixth end 452 is spaced from a rotating axis of the first rotating member 21, and a rotating axis of the eighth end 462 is spaced from a rotating axis of the second rotating member 22. In other words, a pivotally connected joint of the sixth end 452 and the first rotating member 21 is spaced from the rotating axis of the first rotating member 21, and a pivotally connected joint of the eighth end 462 and the second rotating member 22 is spaced from the rotating axis of the second rotating member 22.

The first support 31, the first connecting member 41, the first end 431 of the third connecting member 43 and the fifth end 451 of the fifth connecting member 45 are pivotally connected together by the first pivot shaft, and the second support 33, the second connecting member 42, the third end 441 of the fourth connecting member 44 and the seventh end 461 of the sixth connecting member 46 are pivotally connected together by the second pivot shaft.

Hinges are all folded at a single angle in the related technologies, due to the limitation of the bending radius of the screen of electronic device, the electronic device cannot be completely fit after being folded, and there is a large wedge-shaped gap in the middle of the folded electronic device.

The first connecting member 41, the third connecting member 43 and the fifth connecting member 45 are pivotally connected with the first rotating assembly 3a directly or indirectly, and the second connecting member 42, the fourth connecting member 44 and the sixth connecting member 46 are pivotally connected with the second rotating assembly 3b directly or indirectly. The first support 31, the first connecting member 41, the third connecting member 43, the fifth connecting member 45, the first movable member 32 and the first rotating member 21 can form a multi-segment linkage structure on one side of the hinge 10, and the second support 33, the second connecting member 42, the fourth connecting member 44, the sixth connecting member 46, the second movable member 34 and the second rotating member 22 can form a multi-segment linkage structure on the other side of the hinge 10.

The hinge 10 has a multi-segment linkage structure by arranging the first connecting member 41, the second connecting member 42, the third connecting member 43, the fourth connecting member 44, the fifth connecting member 45 and the sixth connecting member 46, thereby the hinge 10 in the folded state is closer to a drop shape, which better adapts to the shape of the screen after natural bending, and effectively protects the screen. Therefore, the screen of the electronic device in the folded state can be better fit together, and the folded screen is seamless, thereby effectively reducing the thickness of the electronic device in the folded state, so as to realize the thinness of the electronic device and bring better use experience to the user.

The electronic device of the present disclosure has the advantage of a long service life.

In the description of the present disclosure, it should be understood that the orientation and position relationship indicated by the terms "center", "longitudinal", "lateral", "length", "width", "thickness", "up", "down", "front", "back", "left", "right", "vertical", "horizontal", "top", "bottom", "inside", "outside", "clockwise", "counterclockwise", "axial", "radial", "circumferential" and so on are based on the orientation or position relationship shown in the drawings and are intended only to facilitate the description of the present disclosure and simplify the description, rather than indicating or implying that the referred apparatuses or elements must have a specific orientation, must be constructed and operated in a specific orientation, and therefore should not be construed as a limitation to the present disclosure.

In addition, the terms "first" and "second" are only used for descriptive purposes, and cannot be understood as indicating or implying relative importance or implicitly indicating the quantity of indicated technical features. Therefore, the features defined with "first" and "second" can include at least one of the features explicitly or implicitly. In the description of the present disclosure, the meaning of "a plurality of' is two or more, unless otherwise specifically defined.

In the present disclosure, unless otherwise specified and limited, the terms "installed", "connected", "connecting" and "fixed" should be broadly understood, for example, it can be fixed connection, or detachable connection, or integrated; it can be mechanically connected, electrically connected or communicated with each other; it can be directly connected or indirectly connected through an intermediary, and it can be internal connection of two elements or mutual interaction between two elements, unless otherwise specified. For those of ordinary skill in the art, the specific meanings of the above terms in the present disclosure can be understood according to specific situations.

In the present disclosure, unless otherwise specified and limited, the first feature being "on" or "below" the second feature can include the direct contact between the first feature and second feature, and can also include the contact between the first feature and second feature through an intermediary. Furthermore, the first feature being "on," "above" and "on top of' the second feature includes that the first feature is directly above and obliquely above the second feature, or only indicates that the horizontal height of the first feature is higher than that of the second feature. The first feature is "under," "below", "at the bottom of" the second feature includes that the first feature is directly below and obliquely below the second feature, or only indicates that the horizontal height of the first feature is smaller than that of the second feature.

In the present disclosure, the terms "one example", "examples", "specific examples" or "some examples" etc. mean that the specific features, structures, materials or characteristics described in connection with this disclosure are included in at least one example of the present invention.. In this specification, the schematic expression of the above terms must not address the same examples. Furthermore, the specific features, structures, materials, or characteristics described can be combined in an appropriate manner in any one or more or examples. In addition, without contradicting each other, a person skilled in the field can combine and combine the different examples described in this specification and the characteristics of the different examples

Although the examples of the present disclosure have been shown and described above, it can be understood that the above examples are exemplary and cannot be understood as limitations of the present disclosure, and those skilled in the art can make changes, modifications, substitutions and variations to the above examples within the scope of the present disclosure.

## Claims

1. A hinge (10), comprising:
a base (1);
a supporting plate (5); and
a first rotating assembly (3a) and a second rotating assembly (3b), each of the first rotating assembly (3a) and the second rotating assembly (3b) being rotatably disposed on the base between an unfolded position and a folded position, and at least one of the first rotating assembly (3a) and the second rotating assembly (3b) fitting with the supporting plate (5) to move the supporting plate (5) in a thickness direction of the base.

2. The hinge according to claim 1, wherein the base (1) has a support side (111) opposite in the thickness direction and a back side opposite (112) in the thickness direction, wherein at least one of the first rotating assembly (3a) and the second rotating assembly (3b) drives the supporting plate (5) to move toward the support side (111) along the thickness direction when the first rotating assembly (3a) and the second rotating assembly (3b) rotate from the unfolded position to the folded position, and at least one of the first rotating assembly (3a) and the second rotating assembly (3b) drives the supporting plate to move toward the back side along the thickness direction when the first rotating assembly (3a) and the second rotating assembly (3b) are rotated from the folded position to the unfolded position.

3. The hinge according to claim 2, further comprising a first rotating member (21) and a second rotating member (22), the first rotating member (21) being rotatably disposed on the base (1) and connected with the first rotating assembly (3a), the second rotating member (22) being rotatably disposed on the base (1) and connected with the second rotating assembly (3b), and at least one of the first rotating member (21) and the second rotating member (22) being connected with the supporting plate (5), wherein at least one of the first rotating member (21) and the second rotating member (22) drives the supporting plate (5) to move toward the support side (111) along the thickness direction when the first rotating assembly (3a) and the second rotating assembly (3b) are rotated from the unfolded position to the folded position, and the at least one of the first rotating member (21) and the second rotating member (22) drives the supporting plate (5) toward the back side (112) along the thickness direction when the first rotating assembly (3a) and the second rotating assembly (3b) are rotated from the folded position to the unfolded position.

4. The hinge according to any of claims 1-3, wherein the supporting plate (5) is movably disposed on the base (1) along the thickness direction.

5. The hinge according to claim 3, wherein the at least one of the first rotating member (21) and the second rotating member (22) comprises:
a rod body (211) rotatably disposed on the base (1) and connected with a corresponding one of the first rotating assembly (3a) and the second rotating assembly (3b); and
an eccentric part (212) disposed on the rod body (211), spaced from a rotating axis of the rod body (211) in a radial direction of the rod body (211), and connected with the supporting plate (5).

6. The hinge according to claim 5, wherein the at least one of the first rotating member (21) and the second rotating member (22) further comprises a first connecting part (213), the first connecting part (213) extends along the radial direction of the rod body (211), one end of the first connecting part (213) is connected with the rod body (211), and the other end of the first connecting part (213) is connected with the eccentric part (212).

7. The hinge according to claim 5 or 6, wherein
the rotating axis of the rod body (211) is adjacent to the support side (111) relative to the eccentric part (212) in the thickness direction when the first rotating assembly (3a) and the second rotating assembly (3b) are located in the unfolded position; and/or
the eccentric part (212) is adjacent to the support side (111) relative to the rotating axis of the rod body (211) in the thickness direction when the first rotating assembly (3a) and the second rotating assembly (3b) are located in the folded position.

8. The hinge according to any of claims 5 to 7, wherein
the eccentric part (212) is an eccentric post; or
the eccentric part (212) is an eccentric hole, the supporting plate (5) has a second connecting part, and the second connecting part is fitted in the eccentric hole.

9. The hinge according to any of claims 5 to 8, wherein the first rotating member (21) and the second rotating member (22) are spaced along a first direction, the first direction is one of a width direction and a length direction of the base (1), wherein the eccentric part (212) is an eccentric post, the supporting plate (5) comprises a guiding hole (51) extending along the first direction, and the eccentric post is movably fitted in the guiding hole along the first direction.

10. The hinge according to any of claims 1 to 9, wherein one of the base (1) and the supporting plate (5) comprises a first guiding part (115), the other of the base (1) and the supporting plate (5) comprises a second guiding part (52), and the first guiding part (115) is fitted with the second guiding part (52).

11. The hinge according to claim 10, wherein one of the first guiding part (115) and the second guiding part (52) is a guiding post extending in the thickness direction, the other of the first guiding part (115) and the second guiding part (52) is a guiding hole, and the guiding post is fitted in the guiding hole.

12. The hinge according to claim 10 or 11, wherein the first guiding part (115) is plural and the plurality of the first guiding parts (115) are spaced along a second direction, the second guiding part (52) is plural and the plurality of the second guiding parts are spaced along the second direction, wherein the plurality of the first guiding parts (115) are fitted with the plurality of the second guiding parts (52) in one-to-one correspondence, and the second direction is one of a width direction and a length direction of the base.

13. An electronic device, comprising:
a hinge (10) according to any of claims 1-12; and
a wire arrangement (7) connected with the supporting plate (5) of the hinge (10).

14. The electronic device according to claim 13, wherein a middle part (79) of the wire arrangement (7) in its extending direction is connected with the supporting plate (5), and the middle part (79) of the wire arrangement (7) is located between the supporting plate (5) and the base (1) of the hinge (10) in the thickness direction of the base (1) of the hinge (10).

15. The electronic device according to claim 13 or 14, wherein the first rotating member (21 and the second rotating member (22) of the hinge (10) are spaced along a first direction, the first direction is one of a width direction and a length direction of the base (1) of the hinge (10), a first housing (61) of the electronic device (100) is disposed on the first rotating assembly (3a) and has a first inclined face (611), a second housing (62) of the electronic device (100) is disposed on the second rotating assembly (3b) and has a second inclined face (621), and each of the first inclined face (611) and the second inclined face (621) has a first edge (612) and a second edge (613) which are opposite, wherein the first edge (612) and the second edge (613) are opposite in the first direction and are spaced in the thickness direction of the base (1) of the hinge (10) when the first rotating assembly (3a) and the second rotating assembly (3b) are located in the unfolded position, the wire arrangement (7) has a first end (71) and a second end (72) which are opposite in its extending direction, the first end (71) is disposed on the first inclined face (611), and the second end (72) is disposed on the second inclined face (621);
preferably,
the first housing (61) has a first accommodating groove (614), the second housing (62) has a second accommodating groove (622), the first accommodating groove (614) and the second accommodating groove (622) have a first side face and a second side face (615) which are opposite in the first direction when the first rotating assembly (3a) and the second rotating assembly (3b) are located in the unfolded position, the first side face of the first accommodating groove (614) is the first inclined face (611), the first side face of the second accommodating groove (622) is the second inclined surface (621), and the second side face (615) is adjacent to the base (1) relative to the corresponding first side face in the first direction, wherein a portion (77) of the wire arrangement (7) adjacent to the first end (71) is disposed on the second side face (615) of the first accommodating groove (614), and a portion (78) of the wire arrangement (7) adjacent to the second end (72) is disposed on the second side face (615) of the second accommodating groove (622);
preferably,
the second side face (615) has a third edge (616) and a fourth edge (617) which are opposite, when the first rotating assembly (3a) and the second rotating assembly (3b) are located in the unfolded position, the third edge (616) and the fourth edge (617) are opposite in the first direction, the third edge (616) is far from the support side (111) relative to the fourth edge (617) in the thickness direction, and the third edge (616) is far from the base (1) relative to the fourth edge (617) in the first direction; and
preferably,
the first rotating assembly (3a) includes a first support (31) and a first movable member (32) connected with the first rotating member (21), wherein the first housing (61) is disposed on the first movable member (32), a first part (73) of the wire arrangement (7) is connected with the first support (31), and the first part (73) is located, in the extending direction, between the first end (71) and the middle part (79) of the wire arrangement (7) in its extending direction; and
the second rotating assembly (3b) includes a second support (33) and a second movable member (34) connected with the second rotating member (22), the second housing (62) is disposed on the second movable member (34), a second part (74) of the wire arrangement (7) is connected with the second support (33), and the second part (74) is located between the second end (72) and the middle part (79) of the wire arrangement (7) in the extending direction.
